# EUROPÄISCHE PATENTANMELDUNG

(11) **EP 0 744 725 A1**
(43) Veröffentlichungstag der Anmeldung: **27.11.1996**
(21) Anmeldenummer: 96106235.3
(22) Anmeldetag: 20.04.1996
(51) Int. Cl.: G08C 19/02

(54) **Eingangsschaltung für die Erfassung, Auswertung oder Weiterverarbeitung eines Sensorsignals**

(30) Priorität: 27.04.1995 DE 19515491
(71) Anmelder: ABB PATENT GmbH, D-68309 Mannheim (DE)
(72) Erfinder: Röttger, Dieter, 58730 Fröndenberg (DE)
(74) Vertreter: Rupprecht, Klaus, Dipl.-Ing.

(57) **Zusammenfassung**

Die Erfindung betrifft eine Eingangsschaltung für die Erfassung, Auswertung oder Weiterverarbeitung eines Stromsignals (IS) mit einem als Shunt die Stromeingangsanschlüsse (E1, E2) überbrückenden Meßwiderstand (RM), an dem das Stromsignal (IS) einen Spannungsabfall (U) hervorruft, der einer eingangsseitig sehr hochohmigen Verarbeitungsschaltung (V) zugeführt ist. Es soll eine einfach aufgebaute Eingangsschaltung geschaffen werden, die wahlweise Strom- und Spannungssignale aufnehmen kann. Hierzu ist in den Stromkreis zwischen den Meßwiderstand (RM) und die Verarbeitungsschaltung (V) ein erster Spannungsteilerwiderstand (R1) geschaltet. Ein zweiter Spannungsteilerwiderstand (R2) wird mit seinem ersten Ende an einem Spannungseingangsanschluß (E3) und mit seinem zweiten Ende zwischen dem Meßwiderstand (RM) und der Verarbeitungsschaltung (V) angeschlossen. Bei diesem Aufbau steht der Spannungseingangsanschluß (E3) alternativ zum Stromeingangsanschluß (E2) zusammen mit dem gemeinsamen Eingangsanschluß (E1) für Spannungssignale (US) zur Verfügung.

## Beschreibung

Die Erfindungx betrifft eine Eingangsschaltung nach dem Oberbegriff des Anspruchs 1.

Im Bereich der Elektronik müssen häufig Signale, insbesondere von Sensoren abgegebene Signale, die entweder als Stromsignale oder als Spannungssignale vorliegen, von einer Verarbeitungsschaltung aufgenommen werden. In der Regel sind diese Signale bereits soweit aufbereitet, daß sie als normierte Ströme im Bereich von 0 bis 20 mA bzw. 4 bis 20 mA oder als normierte Spannungen im Bereich von 0 bis 10 V abgegeben werden.

Bekannte Verarbeitungsschaltungen besitzen entweder nur strom- oder nur spannungsspezifische Eingangsschaltungen und sind dann nicht universell einsetzbar oder sie weisen zwei getrennte, mit relativ aufwendiger Elektronik ausgerüstete Eingänge auf.

Aufgabe der Erfindung ist es, eine Eingangsschaltung nach dem Oberbegriff des Anspruchs 1 zu schaffen, die sowohl einen Stromals auch einen Spannungseingang besitzt und mit einfachen Mitteln aufgebaut ist.

Diese Aufgabe wird durch die im Anspruch 1 gekennzeichneten Merkmale gelöst. Zweckmäßige Ausgestaltungen und Weiterbildungen des Erfindungsgegenstandes sind in den Unteransprüchen genannt.

Unter der Vorraussetzung, daß die Verarbeitungsschaltung einen sehr hohen Eingangswiderstand besitzt, was in der Regel zutrifft oder aber durch einen vorgeschalteten, als Impedanzwandler wirkenden Verstärker leicht erreichbar ist, kann man in den Eingangskreis zwischen den Meßwiderstand und die Verarbeitungsschaltung einen ersten Spannungsteilerwiderstand einfügen, ohne daß es dadurch zu Fehlern bei der Auswertung von Stromsignalen kommt. Ein zweiter Spannungsteilerwiderstand, der mit seinem ersten Ende an einem Spannungseingangsanschluß und mit seinem zweiten Ende zwischen dem Meßwiderstand und der Verarbeitungsschaltung angeschlossen ist, ermöglicht nun eine Spannungsteilung eines am Spannungseingangsanschluß anliegenden Spannungssignals derart, daß an der Verarbeitungsschaltung eine Teilspannug zu liegen kommt, die dem Verhältnis der Widerstandssumme von Meßwiderstand und erstem Spannungsteilerwiderstand zur Summe aller drei Widerstände entspricht. Es wird somit ein Spannungseingangsanschluß gebildet, der alternativ zum Stromeingangsanschluß unter Einbeziehung des Meßwiderstandes zusammen mit dem gemeinsamen Eingangsanschluß für Spannungssignale zur Verfügung steht.

Bei der Dimensionierung der Spannungsteilerwiderstände ist dafür sorge zu tragen, daß ausgehend von dem für den Bereich der Stromsignale festgelegten Meßwiderstand die für den Bereich der Spannungssignale festzulegenden Spannungsteilerwiderstände so berechnet werden, daß die vorgegebenen Bereichsendwerte des Stromsignals und des Spannungssignals am Meßwiderstand gleich große Spannungen erzeugen.

Eine wichtige Verbesserung der Eingangsschaltung läßt sich dadurch erreichen, daß parallel zum Eingang der Verarbeitungsschaltung ein Kondensator liegt, der mit dem ersten Spannungsteilerwiderstand als RC-Glied eingangsseitige Störsignale unterdrückt.

Es empfiehlt sich dafür zu sorgen, daß zunächst durch Optimierung des RC-Gliedes eine Festlegung des ersten Spannungsteilerwiderstandes erfolgt und die Dimensionierung des zweiten Spannungsteilerwiderstandes entsprechend den Werten des Meßwiderstandes, des ersten Spannungsteilerwiderstandes und des Spannungssignals durchzuführen.

Bei häufig verwendeten Sensorschaltungen hat sich als vorteilhaft erwiesen die Eingangsschaltung so auszulegen, daß für Stromsignale mit einem Endwert von 20 mA und für Spannungssignale mit einem Endwert von 5 V der Meßwiderstand mit 250 Ohm, der erste Spannungsteilerwiderstand mit 10 kOhm, der zweite Spannungsteilerwiderstand mit 10250 Ohm und der Kondensator mit 100 nF dimensioniert werden.

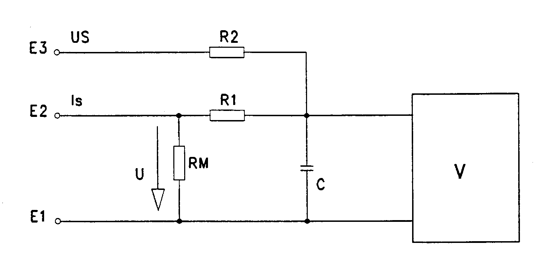

Ein Ausführungsbeispiel der Erfindung ist in der Zeichnung dargestellt und wird im folgenden näher beschrieben.

Dem Schaltbild kann man entnehmen, daß die erfindungsgemäße Eingangsschaltung einen gemeinsame Eingangsanschluß E1, einen Stromeingangsanschluß E2 und einen Spannungseingangsanschluß E3 besitzt. Ausgehend vom Stromeingangsanschluß E2 fließt ein Stromsignal IS über einen Meßwiderstand RM zum gemeinsamen Eingangsanschluß E1 zurück und erzeugt dabei einen Spannungsabfall, der über einen ersten Spannungsteilerwiderstand R1 zum Eingang einer Verarbeitungsschaltung V gelangt. Der erste Spannungsteilerwiderstand R1 kann durchaus im kOhm-Bereich liegen, ohne zu einer Verfälschung des zu erfassenden Stromsignals zu führen, wenn der Eingangswiderstand der Verarbeitungsschaltung V wesentlich hochohmiger ist.

Ein parallel zum Eingang der Verarbeitungsschaltung V liegender Kondensator C bildet mit dem ersten Spannungsteilerwiderstand R1 ein RC-Glied R1, C, das zu einer Ünterdrückung eingangsseitig aufgenommener Störsignale dient. Es ist möglich das RC-Glied R1, C für seine Aufgabe zur Störunterdrückung eigenständig zu optimieren, wobei allerdings ein ausreichender Abstand des Widerstandswertes vom ersten Spannungsteilerwiderstand R1 zum hochohmigen Eingang der Verarbeitungsschaltung V gewährleistet sein muß.

Die vorbeschriebene Eingangsschaltung für Stromsignale IS muß lediglich durch einen einzigen zweiten Spannungsteilerwiderstand R2 ergänzt werden, um mit dieser Eingangsschaltung auch Spannungssignale US zur Weiterverabeitung aufnehmen zu können. Der zweite Spannungsteilerwiderstand R2 liegt hierzu mit seinem einen Ende an dem Spannungseingangsanschluß E3 und mit seinem anderen Ende an der Verbindung zwischen dem ersten Spannungsteilerwiderstand R1 und einem Eingang der Verarbeitungsschaltung V.

In einem Anwendungsfall als universelle Eingangsschaltung für Sensoren hat sich die folgende Dimensionierung bei einem Stromendwert von 20 mA und einem Spannungsendwert von 5 V bewährt:
RM = 250 Ohm
R1 = 10000 Ohm
R2 = 10250 Ohm
C = 100 nF

## Patentansprüche

1. Eingangsschaltung für die Erfassung, Auswertung oder Weiterverarbeitung eines Stromsignals (IS) mit einem als Shunt die Stromeingangsanschlüsse (E1, E2) überbrückenden Meßwiderstand (RM), an dem das Stromsignal (IS) einen Spannungsabfall (U) hervorruft, der einer eingangsseitig sehr hochohmigen Verarbeitungsschaltung (V) zugeführt ist, dadurch gekennzeichnet, daß in den Stromkreis zwischen den Meßwiderstand (RM) und die Verarbeitungsschaltung (V) ein erster Spannungsteilerwiderstand (R1) geschaltet ist und ein zweiter Spannungsteilerwiderstand (R2) mit seinem ersten Ende an einem Spannungseingangsanschluß (E3) und mit seinem zweiten Ende zwischen dem Meßwiderstand (RM) und der Verarbeitungsschaltung (V) angeschlossen ist und daß der Spannungseingangsanschluß (E3) alternativ zum Stromeingangsanschluß (E2) zusammen mit dem gemeinsamen Eingangsanschluß (E1) für Spannungssignale (US) zur Verfügung steht.

2. Eingangsschaltung nach Anspruch 1, dadurch gekennzeichnet, daß ausgehend von dem für den Bereich der Stromsignale (IS) festgelegten Meßwiderstand (RM) die für den Bereich der Spannungssignale (US) festzulegenden Spannungsteilerwiderstände so dimensioniert sind, daß die vorgegebenen Bereichsendwerte des Stromsignals (IS) und des Spannungssignals (US) an der Verarbeitungsschaltung (V) zu gleichgroßen Spannungen führen.

3. Eingangsschaltung nach einem der vorhergehenden Ansprüche, dadurch gekennzeichnet, daß parallel zum Eingang der Verarbeitungsschaltung (V) ein Kondensator liegt, der mit dem ersten Spannungsteilerwiderstand (R1) als RC-Glied (R1, C) eingangsseitige Störsignale unterdrückt.

4. Eingangsschaltung nach Anspruch 3, dadurch gekennzeichnet, daß zunächst durch eine Optimierung des RC-Gliedes (R1, C) eine Festlegung des ersten Spannungsteilerwiderstandes (R1) erfolgt und die Dimensionierung des zweiten Spannungsteilerwiderstandes (R2) entsprechend den Werten des Meßwiderstandes (RM), des ersten Spannungsteilerwiderstandes (R1) und des Spannungssignals (US) durchzuführen ist.

5. Eingangsschaltung nach einem der vorhergehenden Ansprüche, dadurch gekennzeichnet, daß für Stromsignale (IS) mit einem Endwert von 20 mA und für Spannungssignale (US) mit einem Endwert von 5 V der Meßwiderstand (RM) mit 250 Ohm, der erste Spannungsteilerwiderstand (R1) mit 10 kOhm, der zweite Spannungsteilerwiderstand (R2) mit 10250 Ohm und der Kondensator mit 100 nF dimensioniert ist.
